# EUROPEAN PATENT APPLICATION

(11) **EP 1 930 468 A1**
(43) Date of publication of application: **11.06.2008**
(21) Application number: 06781421.0
(22) Date of filing: 21.07.2006
(51) Int. Cl.: C23C 14/56, C23C 16/44

(54) **CHAMBER FOR VACUUM TREATMENT**

(30) Priority: 30.08.2005 JP 2005249284
(71) Applicant: Shinmaywa Industries, Ltd., Takarazuka-shi, Hyogo 665-8550 (JP)
(72) Inventor: IWASAKI, Yasukuni, Takarazuka-shi, Hyogo 665-8550 (JP); FUKUDA, Yoshimitsu, Takarazuka-cho, Hyogo 665-0052 (JP); MIYAZAKI, Osamu, Takarazuka-shi, Hyogo 665-0052 (JP)
(74) Representative: Piésold, Alexander James
(86) International application number: PCT/JP2006/314499
(87) International publication number: WO 2007/026479

(57) **Abstract**

The present invention provides a vacuum chamber capable of simplifying the structure of the arrangement of a cooling passage. The vacuum chamber of the present invention includes a plurality of wall members (1, 2, 3, 4, 11, 12 and 13), the plurality of the wall members (1, 2, 3, 4, 11, 12 and 13) are connected to each other to construct a chamber main body (100) by connection portions (10) where connection surfaces each of which is part of a surface of each wall member (1, 2, 3, 4, 11, 12 and 13) are hermetically connected to each other, and at least part of the connection portions (10) are built-in gap type connection portions (10) each of which has a gap 30 or 31 extending along the corresponding connection surfaces inside the connection surfaces and in which peripheries of the connection surfaces are hermetically connected to each other by welding.

## Description

### Technical Field

The present invention relates to a vacuum chamber, and particularly to a vacuum chamber which includes a plurality of wall members and in which a chamber main body is constructed by connecting each other connection surfaces each of which is part of each wall member.

### Background Art

A film forming apparatus includes an isolated chamber, so-called vacuum chamber, to prevent foreign matters from getting into a film surface at the time of a film forming operation and to generate a film forming material as in the case of sputtering. The vacuum chamber is constructed by attaching instruments, such as a vacuum pump, an isolation valve, a heater, a target, a magnet and a sputter electrode, to a chamber main body constructed by connecting a plurality of wall members each other. At the time of the film forming operation, a substrate is provided in the vacuum chamber, and a film is formed on the surface of the substrate by the operations of the instruments attached to the vacuum chamber.

In the film forming operation, the chamber main body is heated by, for example, heat generated by some of the instruments, such as the sputter electrode, attached to the vacuum chamber and plasma generated in the vacuum chamber. Therefore, the chamber main body is generally provided with a cooling structure (see Patent Documents 1 to 3).
Patent Document 1: Japanese Laid-Open Patent Application Publication No. 2002-164593
Patent Document 2: Japanese Laid-Open Patent Application Publication No. 2002-151763
Patent Document 3: Japanese Laid-Open Patent Application Publication No. 2004-172264

### Disclosure of the Invention

### Problems to be Solved by the Invention

To provide cooling piping on the wall members of the chamber main body as in Patent Document 1 or to provide cooling passages inside the wall members as in Patent Documents 2 and 3, it is necessary to secure enough surfaces of the wall members or inner spaces of the wall members. However, since the number of the instruments attached to the chamber main body is not small, a narrow portion where a narrow surface is formed, such as a portion where attachment portions of instruments are formed adjacent to each other, is formed on the surface of the wall member. In such narrow portion, it is difficult to secure an adequately large surface for providing the passage. Moreover, in a bent portion where a bent surface is formed, such as a corner of the chamber main body or a flange portion formed around the opening of the chamber main body, the problem is that the arrangement of passage piping and the designing of the passages inside the wall members become complex. That is, there is room for improvement of the structure of the arrangement of the cooling passages of the chamber main body.

The present invention was made to solve the above problems, and an object of the present invention is to provide a vacuum chamber capable of simplifying the structure of the arrangement of the cooling passages of the chamber main body.

### Means for Solving the Problems

In order to solve the above problems, a vacuum chamber according to a first aspect of the present invention comprises a plurality of wall members, the plurality of the wall members being connected to each other to constitute a chamber main body by connection portions where connection surfaces each of which is part of a surface of each wall member are hermetically connected to each other, wherein at least part of the connection portions are built-in gap type connection portions each of which has a gap extending along the corresponding connection surfaces inside the connection surfaces and in which peripheries of the connection surfaces are hermetically connected to each other by welding. With this configuration, since the cooling passage can be formed by using the built-in gap type connection portion, it is possible to simplify the structure of the arrangement of the cooling passage in a narrow portion where a narrow surface is formed or in a bent portion where a bent surface is formed. Here, the vacuum chamber is an isolated chamber which is used to prevent foreign matters from getting into a film surface at the time of a film forming operation and to generate a film forming material as in the case of sputtering. Examples are a film forming chamber of a multi-chamber type film forming apparatus, a heat chamber, a plasma cleaning chamber and a load lock chamber. The wall members include not only basic components of the chamber main body, such as a top plate, a side plate and a bottom plate but also members, such as a flange, etc. provided on the basic components.

To surely obtain the effects of the present invention, in a vacuum chamber according to a second aspect of the present invention, the built-in gap type connection portion may be a connection portion forming a bent portion or narrow portion of the chamber main body. Here, the bent portion is a portion where a bent surface is formed, such as a corner of the chamber main body and a flange portion formed around the opening of the chamber main body. The narrow portion is a portion where a narrow surface is formed, such as a portion where attachment portions of equipments are formed adjacent to each other.

To surely obtain the effects of the present invention, in a vacuum chamber according to a third aspect of the present invention, the built-in gap type connection portion may be constructed by connecting each other planar connection surfaces each having a groove.

In a vacuum chamber according to a fourth aspect of the present invention, the built-in gap type connection portion may be formed such that bent connection surfaces engage with each other and a gap is formed at a bent portion of the connection surfaces. With this configuration, since the connection surfaces engage with each other at the bent portion of the connection surfaces, it is possible to facilitate an operation of connecting the wall members each other.

### Effects of the Invention

As above, a vacuum chamber of the present invention can simplify the structure of the arrangement of the cooling passages.

The above object, other objects, features, and advantages of the present invention will be made clear by the following detailed explanation of preferred embodiments with reference to the attached drawings.

### Brief Description of the Drawings

[Fig. 1] Fig. 1 is a perspective view schematically showing a vacuum chamber of an embodiment of the present invention.
[Fig. 2] Fig. 2 is a cross-sectional view taken along a line II-II of Fig. 1, showing a built-in gap type connection portion of a side plate 3 and a side plate 4.
[Fig. 3] Fig. 3 a cross-sectional view taken along a plane III of Fig. 1, showing the built-in gap type connection portion of a side plate 2 and the side plate 4.
[Fig. 4] Fig. 4 is a cross-sectional view taken along a plane IV of Fig. 1, showing the built-in gap type connection portion of a top plate 1 and a flange 5.
[Fig. 5] Fig. 5 is a cross-sectional view taken along a plane V of Fig. 1, showing the built-in gap type connection portion of the top plate 1 and the flange 5.
[Fig. 6] Fig. 6 is a cross-sectional view taken along a plane VI of Fig. 1, showing the built-in gap type connection portion of the side plate 3 and a flange 8.
[Fig. 7] Fig. 7 is a cross-sectional view taken along a plane VII of Fig. 1, showing the built-in gap type connection portion of the side plate 3 and the flange 8.
[Fig. 8] Fig. 8 is a cross-sectional view taken along a plane VIII of Fig. 1, showing the built-in gap type connection portion of the side plate 3 and the flange 8.
[Fig. 9] Fig. 9 is a cross-sectional view taken along the line II-II of Fig. 1, showing a modification example of the built-in gap type connection portion of the side plate 3 and the side plate 4.

### Explanation of Reference Numbers

- 1: top plate
- 1G: upper surface
- 1P: high surface
- 1Q: stepped surface
- 2: side plate
- 2D: groove portion
- 2F: end surface
- 3: side plate
- 3D: groove portion
- 3F: end surface
- 3G: opening edge portion
- 3K: opening surface
- 3P: first end surface
- 3Q: first stepped surface
- 3R: second end surface
- 3S: second stepped surface
- 3T: third end surface
- 3U: oblique surface
- 4: side plate
- 4D: groove portion
- 4F: end surface
- 4G: side edge portion
- 4P: first end surface
- 4Q: first stepped surface
- 4R: second end surface
- 4S: second stepped surface
- 4T: third end surface
- 5, 6, 7, 8, 9: flange
- 5H, 6H, 7H, 8H, 9H: hole
- 5J, 8J: bottom surface
- 5P, 8P: high bottom surface
- 5Q, 8Q: stepped surface
- 10: welding portion
- 11: bottom plate
- 12, 13: side plate
- 15: bolt hole
- 20, 21,: 22, 23 through hole
- 30, 31, 32, 33: passage
- 100: chamber

### Best Mode for Carrying Out the Invention

Hereinafter, the best mode for carrying out the present invention will be explained with reference to the drawings.

### Embodiment

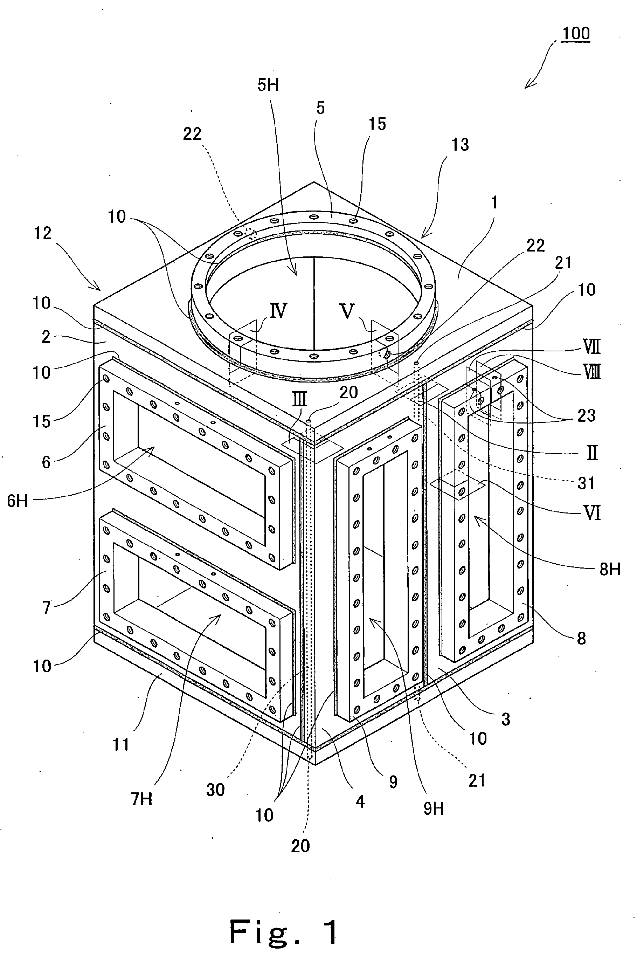

Fig. 1 is a perspective view schematically showing a chamber main body of a vacuum chamber of an embodiment of the present invention. Herein, the vacuum chamber is a film forming chamber.

As shown in Fig. 1, a chamber main body (hereinafter referred to as "chamber") 100 of the film forming chamber of the present embodiment is constructed by connecting each other a top plate 1, a side plate 2, side plates 3, 4, 12 and 13 and a bottom plate 11 that are wall members, so as to be in the shape of a rectangular solid. Welding is used for this connection. To be specific, a welding portion 10 is formed around connection surfaces to constitute a connection portion.

The top plate 1 has a hole 5H for access. A flange 5 is hermetically connected to a circumference of the hole 5H by the welding portion 10. The flange 5 has a plurality of bolt holes 15. Although not shown, at the time of the film forming operation, a closure plate is hermetically attached to the flange 5, and at the time of inspecting or cleaning the film forming apparatus, the closure plate is detached, so that a worker can access the inside of the chamber through the hole 5H.

Similarly, the side plate 2 has a hole 6H through which a substrate that is a film forming target is inserted and taken out and a hole 7H through which a target that is a raw material source of film forming processing is inserted and taken out. Flanges 6 and 7 are hermetically connected, to peripheries of the holes 6H and 7H by the welding portions 10, respectively. Each of the flanges 6 and 7 has a plurality of bolt holes 15. Although not shown, the substrate is inserted into the chamber through the hole 6H and taken out through the hole 6H, and at the time of the film forming operation, a hermetically-closed gate valve, a connection plate or a substrate supporting member is hermetically attached to the flange 6, so that the film forming processing by sputtering or the like can be carried out with respect to the substrate in the chamber 100. Moreover, although not shown, the target is inserted into the chamber 100 through the hole 7H and taken out through the hole 7H, and at the time of the film forming operation, a connection plate or a target supporting member is hermetically attached to the flange 7, so that the film forming processing by sputtering or the like can be carried out with respect to the substrate in the chamber 100.

Similarly, the side plates 3 and 4 have holes 8H and 9H, respectively, for attachment of sputter electrodes. Flanges 8 and 9 are hermetically connected to peripheries of the holes 8H and 9H by the welding portions 10, respectively. Each of the flanges 8 and 9 has a plurality of bolt holes 15. Although not shown, the sputter electrodes are hermetically attached to the holes 8H and 9H, respectively, so that the film forming processing by sputtering or the like can be carried out with respect to the substrate in the chamber. By attaching a plurality of the sputter electrodes, it is possible to cause the film forming materials to reach the surface of the substrate from various directions, so that it becomes easy to equalize the thickness of the film on the surface of the substrate and carry out the film forming processing with respect to a substrate having a complex shape. Therefore, depending on conditions of the film forming processing, such as the shape of the substrate and a plural-film formation, the sputter electrodes may be attached to the side plates 12 and 13, not shown, in the same manner.

Although not shown, the side plate 12 has an exhaust port. A valve is attached to the exhaust port. An exhaust apparatus, such as a vacuum pump, is attached to the valve. With this, it is possible to reduce the pressure in the chamber at the time of the film forming operation.

As above, the chamber 100 includes a plurality of wall members, that is, the top plate 1, the side plates 2, 3, 4, 12 and 13 and the bottom plate 11 and the flanges 5, 6, 7, 8 and 9, and the connection surfaces each of which is part of each wall member are hermetically connected to each other by the welding portions 10.

Here, the construction of a built-in gap type connection portion that is a feature of the present invention will be explained.

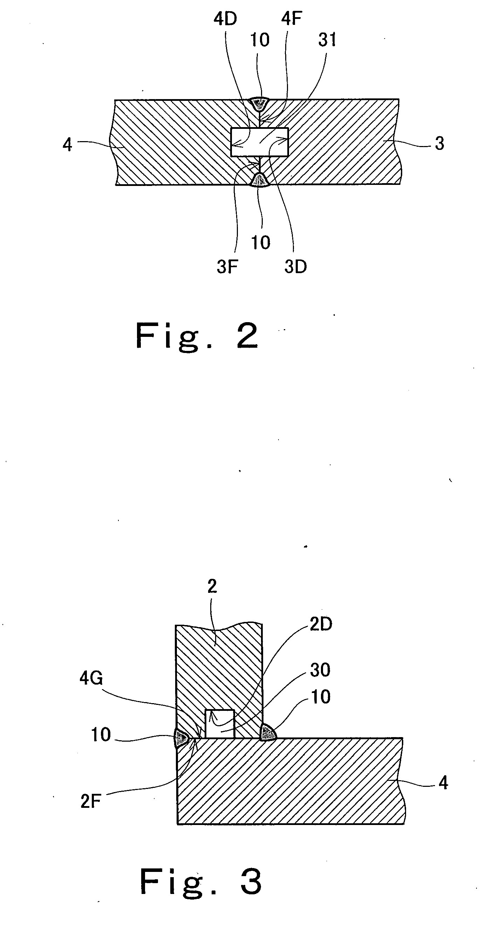

Fig. 2 is a cross-sectional view taken along the line II-II of Fig. 1, showing the built-in gap type connection portion of the side plate 3 and the side plate 4. As shown in Fig. 2, an end surface 3F of the side plate 3 and an end surface 4F of the side plate 4 are connected to each other by butt welding. Thus, the side plate 3 and the side plate 4 constitute one side surface of the chamber 100. The welding portions 10 are formed by continuously depositing welding beads with respect to both edge portions of each of the end surfaces 3F and 4F which have been subjected to edge preparation. With this, both edge portions of the built-in gap type connection portion are hermetically connected to each other.

In a plane which is away from both edge portions of the end surface 3F that is the connection surface, a groove portion 3D is formed so as to extend in a direction in which the end surface 3F extends, and in a plane which is away from both edge portions of the end surface 4F that is the connection surface, a groove portion 4D is formed so as to extend in a direction in which the end surface 4F extends. With this, the groove portions 3D and 4D form a gap which extends along the connection surfaces at the built-in gap type connection portion, and the gap constitutes a passage 31.

Further, as shown in Fig. 1, on the top plate 1 above the built-in gap type connection portion of the side plate 3 and the side plate 4, a through hole 21 is formed so as to be connected to one end portion of the passage 31. Although not shown, also on the bottom plate 11, another through hole 21 is formed so as to be connected to the other end portion of the passage 31. To be specific, the passage 31 is in communication with outside by a pair of the through holes 21.

Therefore, by connecting a pair of the through holes 21 to cooling water piping, it is possible to cause cooling water to flow in the passage 31, so that it is possible to cool down a portion between the flanges 8 and 9. To be specific, since the chamber 100 of the present invention can form the cooling passage by using the built-in gap type connection portion, it can simplify the structure of the arrangement of the cooling passage. Especially, it is possible to simplify the structure of the arrangement of the cooling passage in a narrow portion where a narrow surface is formed, such as a portion where attachment portions of equipments are formed adjacent to each other.

Fig. 3 is a cross-sectional view taken along the plane III of Fig. 1, showing the built-in gap type connection portion of the side plate 2 and the side plate 4.

As shown in Fig. 3, the side plate 2 and the side plate 4 constitute adjacent side surfaces of the chamber 100, and a connection portion of the side plate 2 and the side plate 4 constitutes one of corners of the chamber 100. An end surface 2F of the side plate 2 and a side edge portion 4G of a chamber inner surface-side wall surface of the side plate 4 are hermetically connected to each other by the welding portion 10. The welding portions 10 are formed by continuously depositing the welding beads with respect to portions which are located on both sides of the end surface 2F subjected to the edge preparation and are between the end surface 2F and the side edge portion 4G. With this, both edge portions of the built-in gap type connection portion are hermetically connected to each other at the corner of the chamber 100.

In the end surface 2F that is the connection surface, a groove portion 2D is formed so as to extend in a direction in which the end surface 2F extends. With this, the groove portion 2D and the side edge portion 4G form a gap which extends along the connection surface at the built-in gap type connection portion, and the gap constitutes a passage 30.

Further, as shown in Fig. 1, on the top plate 1 above the built-in gap type connection portion of the side plate 2 and the side plate 4, a through hole 20 is formed so as to be connected to one end portion of the passage 30. Although not shown, also on the bottom plate 11, another through hole 20 is formed so as to be connected to the other end portion of the passage 30. Thus, the passage 30 is in communication with outside by a pair of the through holes 20.

Therefore, by connecting a pair of the through holes 20 to the cooling water piping, it is possible to cause the cooling water to flow in the passage 30, so that it is possible to cool down the bent portion between the flanges 9 and 6 and between the flanges 9 and 7. To be specific, since the chamber 100 of the present invention can form the cooling passage by using the built-in gap type connection portion, it can simplify the structure of the arrangement of the cooling passage. Especially, it is possible to simplify the structure of the arrangement of the cooling passage in a bent portion where a bent surface is formed, such as the corner of the chamber 100.

Moreover, since it is unnecessary to form a groove portion on the side plate 4, it is possible to reduce the manufacturing cost of the chamber 100.

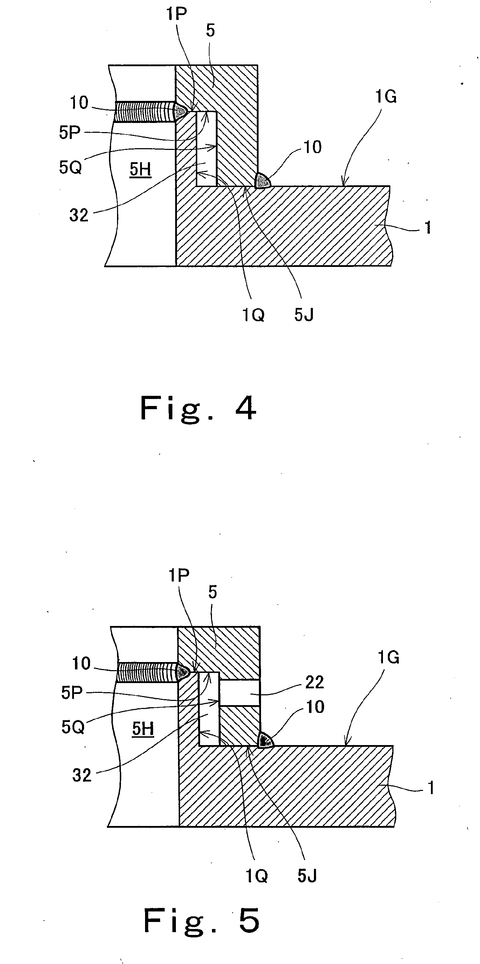

Fig. 4 is a cross-sectional view taken along the plane IV of Fig. 1, showing the built-in gap type connection portion of the top plate 1 and the flange 5. Fig. 5 is a cross-sectional view taken along the plane V of Fig. 1, showing the built-in gap type connection portion of the top plate 1 and the flange 5.

As shown in Figs. 4 and 5, an upper surface 1G of the top plate 1 and a bottom surface 5J of the flange 5 are hermetically connected to each other by the welding portion 10.

Specifically, a high surface 1P is formed at a hole 5H-side edge portion of the upper surface 1G, and a stepped surface 1Q is formed between the high surface 1P and the upper surface 1G. A portion on the hole 5H side of the bottom surface 5J, that is, a portion on the inner peripheral side of the flange 5 is cut out to form a high bottom surface 5P, and a stepped surface 5Q is formed between the high bottom surface 5P and the bottom surface 5J.

The surface-to-surface distance between the high surface 1P and upper surface 1G of the top plate 1 is equal to the surface-to-surface distance between the high bottom surface 5P and bottom surface 5J of the flange 5. The width of the high surface 1P of the top plate 1 in a radial direction of the hole 5H is formed so as to be smaller than the width of the high bottom surface 5P of the flange 5 in the radial direction of the hole 5H. With this, when connecting the flange 5 and the top plate 1, the high surface 1P of the top plate 1 and the high bottom surface 5P of the flange 5 are connected to each other, and the upper surface 1G of the top plate 1 and the bottom surface 5J of the flange 5 are connected to each other. Thus, an annular gap is formed, which is defined by the stepped surface 1Q, the stepped surface 5Q, the upper surface 1G and the high bottom surface 5P. The welding portion 10 is formed by continuously depositing the welding beads with respect to a portion between a hole 5H-side edge portion of the high surface 1P and a hole 5H-side edge portion of the high bottom surface 5P which edge portions are subjected to the edge preparation. Moreover, as shown in Figs. 1, 4 and 5, on the outer peripheral side of the flange 5, the welding portion 10 is formed by continuously depositing the welding beads with respect to a portion between the outer edge portion of the bottom surface 5J and the wall surface 1G. With this, the welding portions 10 are annularly formed at inner and outer peripheral portions of the annular connection surfaces of the flange 5 and the top plate 1, so that the peripheries of the annular connection surfaces of the flange 5 and the top plate 1 are hermetically connected to each other. Then, a gap is formed so as to annularly extend along the connection surfaces, and the gap constitutes a passage 32.

As shown in Figs. 5 and 1, a pair of through holes 22 connected to the passage 32 are formed on the outer peripheral surface of the flange 5 so as to be located opposite to each other with the hole 5H located therebetween. Thus, the passage 32 is in communication with outside by a pair of the through holes 22.

Therefore, by connecting a pair of the through holes 22 to the cooling water piping, it is possible to cause the cooling water to flow in the passage 32. Moreover, there are two passages between one through hole 22 and the other through hole 22. Since resistances of these passages are substantially equal to each other, the cooling water supplied from one through hole 22 may be divided into two so as to flow in the passage 32. That is, the chamber 100 of the present invention can secure the cooling passage by using the built-in gap type connection portion. Therefore, it is possible to simplify the structure of the arrangement of the cooling passage. Especially, it is possible to simplify the structure of the arrangement of the cooling passage at the bent portion where the flange 5 is constructed and the bent surface is formed.

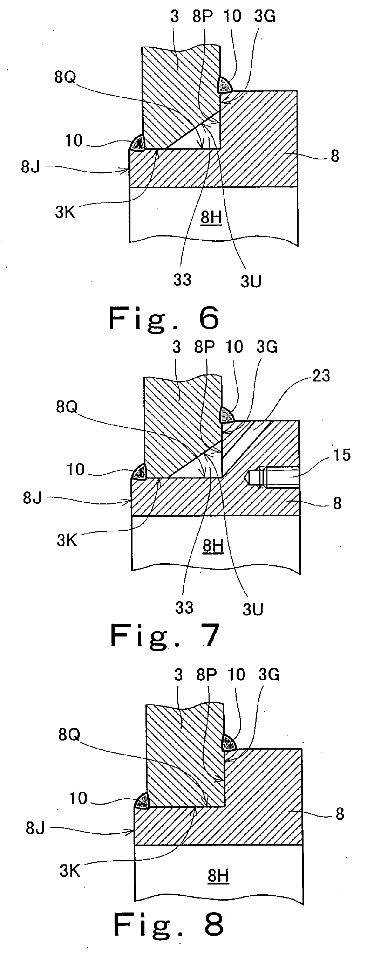

Fig. 6 is a cross-sectional view taken along the plane VI of Fig. 1, showing the built-in gap type connection portion of the side plate 3 and the flange 8. Fig. 7 is a cross-sectional view taken along the plane VII of Fig. 1, showing the built-in gap type connection portion of the side plate 3 and the flange 8. Fig. 8 is a cross-sectional view taken along the plane VIII of Fig. 1, showing the built-in gap type connection portion of the side plate 3 and the flange 8. Although not explained herein, the flange 6 and the side plate 2, the flange 7 and the side plate 2, and the flange 9 and the side plate 4 are constructed in the same manner as above.

As shown in Figs. 6, 7 and 8, an opening surface 3K, forming the hole 8H of the side plate 3, and a bottom surface 8J of the flange 8 are hermetically connected to each other by the welding portion 10.

Specifically, as shown in Figs. 6 and 7, an outer peripheral portion of the bottom surface 8J is cut out over the entire periphery so that the bottom surface 8J fits the opening surface 3K which forms the hole 8H. To be specific, a high bottom surface 8P is formed at an outer peripheral edge portion of the bottom surface 8J, and a stepped surface 8Q is formed between the high bottom surface 8P and the bottom surface 8J. Therefore, the stepped surface 8Q fits the opening surface 3K. An outer surface-side portion of the opening surface 3K is chamfered to form an oblique surface 3U. The oblique surface 3U is formed so as to contact the high bottom surface 8P and the stepped surface 8Q when the flange 8 is attached to the hole 8H of the side plate 3. Thus, an annular gap is formed, which is defined by the high bottom surface 8P, the stepped surface 8Q and the oblique surface 3U.

As shown in Figs. 1 and 6 to Fig. 8, the welding portions 10 are formed by continuously depositing the welding beads with respect to chamber 100-inside edge portion and chamber 100-outside edge portion of the connection surfaces of the side plate 3 and the flange 8, that is, one edge portion of the connection surfaces of the opening surface 3K and the stepped surface 8Q and one edge portion of the connection surfaces of an opening edge portion 3G of a chamber inner surface-side wall surface of the side plate 3 and the high bottom surface 8P. With this, the welding portions 10 are annularly formed at inner and outer peripheral portions of the annular connection surfaces of the flange 8 and the side plate 3, respectively, so that the peripheries of the annular connection surfaces of the flange 8 and the side plate 3 are hermetically connected to each other. And, a gap is formed so as to annularly extend along the connection surfaces. The gap constitutes a passage 33.

As shown in Figs. 1 and 7, a pair of through holes 23 are adjacently formed on the outer peripheral surface of the flange 8 so as to be connected to the passage 33. Thus, the passage 33 is in communication with outside by a pair of the through holes 23.

As shown in Fig. 8, the opening surface 3K is not chamfered at a portion which is part of the connection portion of the flange 8 and the side plate 3 and is adjacent to a pair of the adjacent through holes 23. To be specific, the passage 33 is not formed at the portion which is adjacent to a pair of the adjacent through holes 23. With this, when the cooling water is supplied from one of the through holes 23, the cooling water flows in the passage 33 so as to go around the hole 8H of the side plate 3 and is discharged from the other through hole 23. To be specific, since the chamber 100 of the present invention can secure the cooling passage by utilizing the built-in gap type connection portion, it is possible to simplify the structure of the arrangement of the cooling passage. Especially, it is possible to simplify the structure of the arrangement of the cooling passage at the bent portion and the narrow portion, such as a portion around the hole 8H where the flange 8 is constructed and the flange 9 is adjacent thereto.

### Modification Example

A modification example of the built-in gap type connection portion of the side plate 3 and the side plate 4 will be explained.

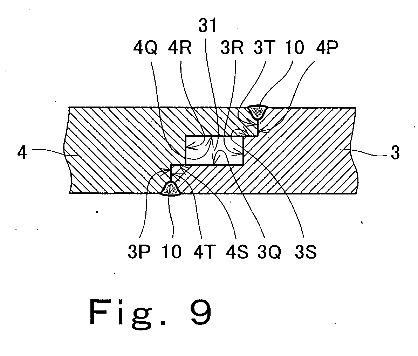

Fig. 9 is a cross-sectional view taken along the line II-II of Fig. 1, showing the modification example of the built-in gap type connection portion of the side plate 3 and the side plate 4.

As shown in Fig. 9, each of the connection surface of the side plate 3 and the connection surface of the side plate 4 is processed so as to have a bent shape. These bent connection surfaces engage with each other, so that a passage-like gap is formed at the bent portion of the connection surfaces so as to extend in a direction in which first end surfaces 3P and 4P extend, that is, in a direction substantially perpendicular to the sheet of Fig. 9. To be specific, on the connection surface of the side plate 3, the first end surface 3P, a second end surface 3R and a third end surface 3T are formed on different levels, a first stepped surface 3Q is formed between the first end surface 3P and the second end surface 3R, and a second stepped surface 3S is formed between the second end surface 3R and the third end surface 3T. Similarly, on the connection surface of the side plate 4, the first end surface 4P, a second end surface 4R and a third end surface 4T are formed on different levels, a first stepped surface 4Q is formed between the first end surface 4P and the second end surface 4R, and a second stepped surface 4S is formed between the second end surface 4R and the third end surface 4T. The surface-to-surface distance between the first end surface 3P and third end surface 3T of the side plate 3 is equal to the surface-to-surface distance between the first end surface 4P and third end surface 4T of the side plate 4. Moreover, the width of the second end surface 3R of the side plate 3 in a thickness direction is equal to the width of the second end surface 4R of the side plate 4 in the thickness direction. With this, when the side plates 3 and 4 are connected to each other, the first end surface 3P of the side plate 3 and the third end surface 4T of the side plate 4 are connected to each other, and the third end surface 3T of the side plate 3 and the first end surface 4P of the side plate 4 are connected to each other. And, the first stepped surface 3Q of the side plate 3 and the second stepped surface 4S of the side plate 4 engage with each other, and the second stepped surface 3S of the side plate 3 and the first stepped surface 4Q of the side plate 4 engage with each other. Thus, a passage-like gap is formed, which is defined by the second end surfaces 3S and 4S and the first stepped surfaces 3Q and 4Q. Then, both edge portions of the built-in gap type connection portion are hermetically connected to each other by the welding portions 10, that is, a region between one edge portion of the first end surface 3P of the side plate 3 and one edge portion of the third end surface 4T of the side plate 4 and a region between one edge portion of the third end surface 3T of the side plate 3 and one edge portion of the first end surface 4P of the side plate 4 are hermetically connected to each other by the welding portions 10. And, a gap is formed so as to extend along the connection surfaces. The gap constitutes the passage 31. When the connection surface has a bent shape as described above, the connection surfaces engage with each other at the bent portion in the connection surfaces. Therefore, it is possible to facilitate an operation of connecting the side plate 3 and the side plate 4.

The embodiment of the present invention is explained above in detail, however the foregoing explanation should be interpreted only as an example since the present embodiment is provided for the purpose of teaching the best mode for carrying out the present invention. Therefore, the present invention is not limited to the above embodiment, but many modifications and other embodiments of the present invention are obvious to one skilled in the art within the scope of the present invention.

For example, the built-in gap type connection portion formed between the side plate 3 and the side plate 4 can be constructed without the through holes 21 formed on the top plate 1 and the bottom plate 11. To be specific, by connecting the top plate 1 and the side edge portions of the wall surfaces of the side plates 3 and 4, connecting the bottom plate 11 and the side edge portions of the wall surfaces of the side plates 3 and 4, and constructing the gap of the built-in gap type connection portion between the side plate 3 and the side plate 4 such that the gap penetrates upward and downward, the through holes 21 on the top plate 1 and the bottom plate 11 can be omitted.

Moreover, the above embodiment has been directed to the film forming chamber. However, the present invention is widely applicable to vacuum chambers that are isolated chambers to prevent foreign matters from getting into a film surface at the time of the film forming operation and to generate the film forming material as in the case of sputtering. For example, the present invention can be carried out in a film forming chamber of a multi-chamber type film forming apparatus, a heat chamber, a plasma cleaning chamber and a load lock chamber.

### Industrial Applicability

A vacuum chamber of the present invention is useful in that it is possible to simplify the structure of the arrangement of the cooling passage.

## Claims

1. A vacuum chamber comprising a plurality of wall members, the plurality of the wall members being connected to each other to constitute a chamber main body by connection portions where connection surfaces each of which is part of a surface of each wall member are hermetically connected to each other, wherein
at least part of the connection portions are built-in gap type connection portions each of which has a gap extending along the corresponding connection surfaces inside the connection surfaces and in which peripheries of the connection surfaces are hermetically connected to each other by welding.

2. The vacuum chamber according to claim 1, wherein the built-in gap type connection portion is a connection portion forming a bent portion or narrow portion of the chamber main body.

3. The vacuum chamber according to claim 1 or 2, wherein the built-in gap type connection portion is constructed by connecting each other planar connection surfaces each having a groove.

4. The vacuum chamber according to claim 1 or 2, wherein the built-in gap type connection portion is formed such that bent connection surfaces engage with each other and a gap is formed at a bent portion of the connection surfaces.
